# EUROPEAN PATENT APPLICATION

(11) **EP 0 917 000 A2**
(43) Date of publication of application: **19.05.1999**
(21) Application number: 98121536.1
(22) Date of filing: 17.11.1998
(51) Int. Cl.: G03F 7/022

(54) **Positive resist composition and method for forming a resist pattern**

(30) Priority: 17.11.1997 JP 314975/97; 10.04.1998 JP 99617/98; 21.07.1998 JP 204790/98
(71) Applicant: Sumitomo Chemical Company, Limited, Chuo-ku Osaka 541-8550 (JP)
(72) Inventor: Uetani, Yasunori, Toyonaka-shi, Osaka (JP)
(74) Representative: VOSSIUS & PARTNER

(57) **Abstract**

A method for forming a resist pattern excellent in heat resistance which comprises coating a positive resist composition comprising an active agent which has no sensitivity against the wavelength of patterning exposure but is able to generate an acid or a radical on a substrate to form a resist film; and, after the development, generating an acid or radical from the active agent for curing;
a positive resist composition used in the method and comprising an alkali-soluble novolak resin, a quinonediazide-based radioactive ray-sensitive agent, the active agent and a cross-linking agent; and
a method for forming a fine positive resist pattern, a hole pattern, which comprises, after patterning exposure and development, irradiating the resist pattern obtained with a light having wavelength shorter than that used for the patterning exposure; and then heating the irradiated pattern at temperature sufficient for allowing the resist pattern to swell are provided.

## Description

The present invention relates to a method for forming a positive resist pattern, and a positive resist composition used for the same.

In more detail, the present invention relates to a method for forming a positive resist pattern having excellent heat resistance and a method for forming a fine positive resist pattern, the resist pattern being formed by irradiation of a radioactive ray such as a ultraviolet ray and a development by alkaline developer and being used for manufacture of a semiconductor integrated circuit, and a positive resist composition used for the same.

A positive resist comprising a novolak resin, as an alkali-soluble component, and a quinonediazide compound, as a radioactive ray-sensitive component, gives a positive type image by irradiation of a radioactive ray through a mask (what is called patterning exposure) and development by alkaline developer by utilizing phenomenon that the quinonediazide compound is decomposed by the action of the radioactive ray to generate a carboxyl group and consequently alkali-insoluble condition turns to alkali-soluble condition. Such a novolak/quinonediazide-based positive resist is widely used for manufacture of integrated circuits since the resist is generally excellent in resolution.

For a positive resist, high heat resistance is required in addition to the other various properties such as resolution, sensitivity and profile. For example, in an ion implantation process and a reflow process wherein heat is generated significantly, high heat resistance is necessary.

The ion implantation is a process in which ions such as boron and phosphorus are implanted into a semiconductor substrate using a resist pattern as a mask. In implanting an ion, high energy is generated and the process leads to high temperature which often causes the resist pattern sagged or tumbled. Due to the resist pattern sagged or tumbled, a correct circuit is not formed. Therefore, a positive resist pattern having excellent heat resistance is required in an ion implantation process.

The reflow is a method which is proposed for forming a fine contact hole pattern using a positive resist. In the reflow, the dimension of a hole pattern (part where a resist film has been removed) is decreased by inflating a resist by heating the resist pattern after development, and by this, it becomes possible to manufacture a further minute integrated circuit. The reflow is conducted at a temperature of about 110 to 180°C. The reflow may be effected in one-step heating at relatively high temperature or in two-step heating wherein operation is first carried out at lower temperature and then carried out at higher temperature. In either case, a high temperature from about 140 to 180°C is adopted in the final stage. Therefore, a positive resist pattern having high heat resistance is preferable since, using the same, dimension control becomes correct.

Heat resistance of a positive resist pattern can be improved by increasing the molecular weight of a resin comprised in the resist. However, when the molecular weight is so increased that the resin is endowed with sufficient heat resistance, there is a tendency of deterioration of basic properties such as decrease in resolution and generation of development residue (scum).

An object of the present invention is to provide a novel method for forming a positive resist pattern having excellent heat resistance and a novel method for forming a fine positive resist pattern, and to provide a positive resist composition suitable for the methods. This object has been achieved by the surprising finding that the heat resistance of a positive resist pattern can be significantly improved without decrease in sensitivity and resolution by incorporating a certain kind of a compound to a positive resist composition comprising a novolak resin, an alkali-soluble component, and a quinonediazide compound, a radioactive ray-sensitive component, and by generating an acid or radical from the compound for curing after alkaline development. It has further been found that sufficient result can be obtained particularly in reflow treatment by irradiating a light having certain wavelength after exposure and development even if no active agent as described above is incorporated in a positive resist composition.

Thus, the present invention provides a method for forming a resist pattern which comprises coating a positive resist composition comprising an alkali-soluble novolak resin, a quinonediazide-based radioactive ray-sensitive agent and an active agent which has no sensitivity against the wavelength of patterning exposure but is able to generate an acid or a radical on a substrate to form a resist film; subjecting the resist film to patterning exposure; conducting a development with an alkaline developer; and generating an acid or radical from the active agent for curing. According to this method, a resist pattern excellent in heat resistance is formed.

The present invention also provides a positive resist composition (hereinafter referred to as "a positive resist composition (A)") used for this method.

The present invention further provides a method for forming a resist pattern which comprises coating a positive resist composition comprising an alkaline-soluble novolak resin and a quinonediazide-based radioactive ray-sensitive agent on a substrate to form a resist film; subjecting the resist film to patterning exposure; conducting development with an alkaline developer; irradiating the resist pattern thus obtained with a light having wavelength shorter than that used for the patterning exposure; and then heating the irradiated pattern at temperature sufficient for allowing the resist pattern to swell to obtain a resist pattern in which the area of part from which a resist is removed is contracted. According to this method, a fine positive resist pattern, a hole pattern, is formed. (Hereinafter, the positive resist composition used in this method is referred to as "a positive resist composition (B)".)

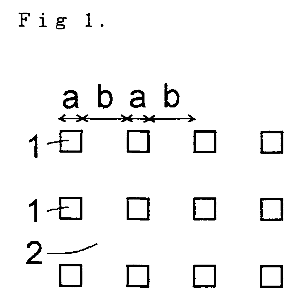

Fig. 1 is a plan view showing one part of a resist pattern which is provided by the mask used in the Experiment examples at optimum exposure conditions in enlarged size.

### Explanation of Marks

1: hole (part from which a resist is removed by exposure and development)
2: image which is not exposed and remains as a resist layer
a: length of one edge of a hole
b: interval between holes

The alkali-soluble novolak resin comprised in the positive resist composition (A) or (B) may be that which is generally used as an alkali-soluble component of a positive resist, and usually obtained by condensation of a phenol-based compound with an aldehyde in the presence of an acid catalyst. Examples of the phenol-based compound used for the manufacture of the novolak resin include phenol, o-, m- or p-cresol, 2,3-, 2,5-, 3,4- or 3,5-xylenol, 2,3,5-trimethylphenol, 2-, 3- or 4-tert-butylphenol, 2-tert-butyl-4- or -5-methylphenol, 2-, 4- or 5-methylresorcinol, 2-, 3- or methoxyphenol, 2,3-, 2,5- or 3,5-dimethoxyphenol, 2-methoxyresorcinol, 4-tert-butylcatechol, 2-, 3- or 4-ethylphenol, 2,5- or 3,5-diethylphenol, 2,3,5-triethylphenol, 2-naphthol, 1,3-, 1,5- or 1,7-dihydroxynaphthalene, and polyhydroxytriphenylmethane-based compounds obtained by condensation of xylenol with hydroxybenzaldehyde. These phenol-based compounds can be used respectively alone or in combination of two or more.

Examples of the aldehyde used for the manufacture of the novolak resin include aliphatic aldehydes such as formaldehyde, acetaldehyde, propionaldehyde, n-butylaldehyde, isobutylaldehyde, pivaldehyde, n-hexylaldehyde, acrolein and crotonaldehyde, alicyclic aldehydes such as cyclohexanealdehyde, cyclopentanealdehyde, furfural and furylacrolein, aromatic aldehydes such as benzaldehyde, o-, m- or p-methylbenzaldehyde, p-ethylbenzaldehyde, 2,4-, 2,5-, 3,4- or 3,5-dimethylbenzaldehyde, o-, m- or p-hydroxybenzaldehyde, o-, m- or p-anisealdehyde and vanillin, and aromatic aliphatic aldehydes such as phenylacetaldehyde and cinnamaldehyde. These aldehydes can also be used respectively alone or in combination of two or more if required. Among them, formaldehyde is preferably used because of industrial availability.

Examples of the acid catalyst used for condensation of a phenol-based compound with an aldehyde include inorganic acids such as hydrochloric acid, sulfuric acid, perchloric acid and phosphoric acid, organic acids such as formic acid, acetic acid, oxalic acid, trichloroacetic acid and p-toluenesulfonic acid, and divalent metal salts such as zinc acetate, zinc chloride and magnesium acetate. These acid catalysts can also be used respectively alone or in combination of two or more. The condensation reaction can be conducted according to a conventional method, and it can be conducted, for example, at a temperature in the range from 60 to 120°C for 2 to 30 hours.

Regarding the novolak resin obtained by condensation, the proportion of components having a molecular weight of 1,000 or less is preferably 25% or less and more preferably it is 20% or less based on the total pattern area excepting unreacted phenol-based compounds. Such preferred novolak resin can be obtained, for example, by fractionation. The proportion is expressed in terms of area ration in gel permeation chromatography (GPC) pattern. Herein, the pattern area is that measured by using a 254 nm UV detector, and the molecular weight is a molecular weigh in terms of polystyrene.

An alkali-soluble lower molecular weight phenol-based compound, such as that having a molecular weight of 1,000 or less, may be added to the novolak resin in which the higher molecular components content has thus been increased. The alkali-soluble lower molecular weight phenol-based compound preferably has at least two phenolic hydroxyl groups in the molecular structure. Examples thereof include those described in JP-A-2-275955 (= USP 5,456,995 and USP 5,456,996) or JP-A-2-2560 and a certain kind of bis or tris-phenol type compounds . When an alkali-soluble phenol-based compound having a molecular weight of 1,000 or less is used, amount of the compound is preferably from 3 to 40% by weight based on the total amount of the novolak resin and the alkali-soluble phenol-based compound.

The quinonediazide-based radioactive ray-sensitive agent in the positive resist (A) or (B) may also be that which is generally used in the field of positive resists. It is usually an o-quinonediazidesulfonate of a compound having a phenolic hydroxyl group. Preferably, it is a 1,2-naphthoquinonediazide-5- or 4-sulfonate or 1,2-benzoquinonediazide-4-sulfonate of a polyhydroxy compound having at least three phenolic hydroxyl groups. Such esters can be produced by reacting the above-described compound having a phenolic hydroxyl groups with an o-quinonediazidesulfonic acid halide in the presence of a base such as triethylamine. It is particularly preferable that the o-quinonediazidesulfonic acid halide is 1,2-naphthoquinonediazide-5-sulfonic acid chloride. The quinonediazide-based radioactive ray-sensitive agent can be used respectively alone or in combination of two or more. Amount of the radioactive ray-sensitive agent comprised in the resist composition is preferably from 10 to 100% by weight, more preferably from 10 to 50% by weight based on the total amount of the novolak resin and the above-described alkali-soluble lower molecular weight phenol-based compound optionally used.

The active agent comprised in the positive resist (A) has no sensitivity against the wavelength of a light used in conducting exposure of a resist film for patterning, such as g-line of 436 nm and i-line of 365 nm, but generates an acid or radical in the treatment conducted after patterning exposure. Specifically, a so-called light acid generator which has no sensitivity against a light having wavelength used for patterning exposure and is decomposed by a light having wavelength other than the wavelength used for patterning exposure and generates an acid; a compound which generates an acid by heating (sometimes referred to as a heat acid generator, in this specification); a compound which generates a radical by heating (sometimes referred to as a radical generator, in this specification), and the like can be listed.

In the method of the present invention in which a positive resist composition comprising an active agent is used, an acid or radical is generated from the active agent for curing, for example, through the following methods 1-3 as well as by other method:

### Method 1:

A light acid generator, a compound which has no sensitivity against the wavelength of patterning exposure but has a sensitivity against a light of other wavelength, is used as an active agent, and the resist pattern after development is irradiated with a light of a wavelength against which the light acid generator has sensitivity to generate an acid, and, then, the resist pattern is heated for curing.

### Method 2

A compound which generates an acid by heating is used as an active agent, and the resist pattern after development is heated for generating an acid and for curing.

### Method 3

A compound which generates a radical by heating is used as an active agent, and the resist pattern after development is heated for generating a radical and for curing.

As the light acid generator, various compounds which are known in the field of chemical amplification type resist can be particularly used. Examples thereof include onium salt compounds, organic halogen compounds, sulfone compounds, and sulfonate compounds.

Examples of the onium salt compound used as a light acid generator include iodonium salts represented by the following formula (I) and sulfonium salts represented by the following formula (II): 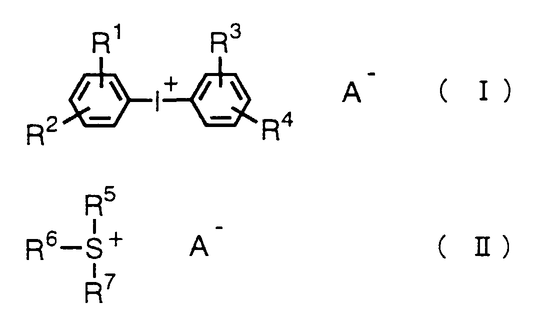 wherein, R¹, R², R³ and R⁴ each independently represents hydrogen, alkyl or alkoxy, R⁵ represents aryl or aryloylmethyl, R⁶ and R⁷ each independently represents alkyl or aryl or R⁶ and R⁷ may form an alkylene in combination, and A represents an acid residue containing fluorine.

Examples of the organic halogen compound used as a light acid generator include halogen-containing triazine compounds represented by the following formula (III): 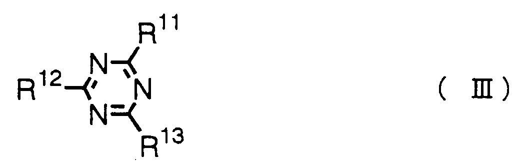 wherein, R¹¹ represents perhaloalkyl, R¹² and R¹³ each independently represents unsubstituted or substituted alkyl, aryl or unsubstituted or substituted styryl.

Examples of the sulfone compound used as a light acid generator include compounds represented by the following formula (IV):

R²¹-SO₂-X-Y-R²² (IV)

wherein, R²¹ and R²² each independently represents alkyl, cycloalkyl or aryl, X represents a direct bond or diazomethylene, and Y represents -CO- or -SO₂-.

Examples of the sulfonate compound used as a light acid generator include aromatic compounds represented by the following formula (V) and sulfonates of N-hydroxyimide represented by the following formula (VI): 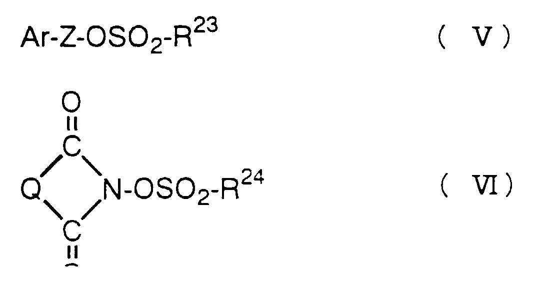 wherein, Ar represents phenyl having nitro or methylsulfonyloxy, α-benzoylbenzyl or α-benzoyl-α-hydroxybenzyl, R²³ represents alkyl or aryl, R²⁴ represents unsubstituted or substituted alkyl, alicyclic hydrocarbon residue, aryl, aralkyl or a camphor group, Z represents a direct bond or methylene, and Q represents a divalent hydrocarbon group.,

In the above formulae, it is usual that the alkyl and alkoxy respectively have about 1 to 6 carbon atoms, and the cycloalkyl have about 5 to 8 carbon atoms. The aryl is usually phenyl or naphthyl, the aralkyl is usual benzyl. The phenyl and naphthyl may be optionally substituted with a group such as hydroxyl group, nitro, halogen, alkyl or alkoxy having the above-described number of carbon atoms, aryloxy or arylthio. Further, two adjacent carbon atoms in these phenyl and naphthyl may be optionally connected by a divalent group such as methylenedioxy. As the substituent on the alkyl, halogens such as chlorine and fluorine are listed.

In the formula (II), the alkylene chain formed by connecting R⁶ and R⁷ may have about 2 to 6 carbon atoms.

Examples of the anion represented by A⁻ in the formulae (I) and (II) include a tetrafluoroborate ion (BF₄⁻), hexafluorophosphate ion (PF₆⁻), hexafluoroantimonate ion (SbF₆⁻) and trifluoromethanesulfonate ion (CF₃SO₃⁻). The halogen constituting the perhaloalkyl represented by R¹¹ in the formula (III) may be fluorine or chlorine. When R¹² and/or R¹³ represents styryl, examples of the group which can be substituted on the benzene ring of tie styryl include alkyl and alkoxy having about 1 to 6 carbon atoms.

In the formula (VI), the alicyclic hydrocarbon residue represented by R²⁴ may be a monocyclic or cross-linked polycyclic ring having about 5 to 16 carbon atoms. Specifically, cyclohexyl, adamantyl and the like are listed. In the formula (VI), the camphor group represented by R²⁴ is a monovalent group derived from camphor. Specifically, 10-camphor group, namely, a group obtained by removing a sulfonic group from 10-comphor sulfonic acid, may be listed. Further, in the formula (VI), the divalent hydrocarbon residue represented by Q may be selected from wide range of groups such as alkylene, arylene and alicyclic divalent group. Specific examples thereof include ethylene, trimethylene, 1,2-phenylene, 1,8-naphthylene and 5-norbornene-2,3-diyl.

Examples of the iodonium salt represented by the formula (I) include:
diphenyliodonium trifluoromethanesulfonate,
4-methoxyphenylphenyliodonium hexafluoroantimonate,
4-methoxyphenylphenyliodonium trifluoromethanesulfonate,
bis(4-tert-butylphenyl)iodonium tetrafluoroborate,
bis(4-tert-butylphenyl)iodonium hexafluorophosphate,
bis(4-tert-butylphenyl)iodonium hexafluoroantimonate and bis(4-tert-butylphenyl)iodonium trifluoromethanesulnonate.

Examples of the sulfonium salt represented by the formula (II) include:
triphenylsulfonium hexafluorophosphate,
triphenylsulfonium hexafluoroantimonate,
triphenylsulfonium trifluoromethanesulfonate,
4-methoxyphenyldiphenylsulfonium hexafluoroantimonate,
4-methoxyphenyldiphenylsulfonium trifluoromethanesulfonate,
p-tolyldiphenylsulfonium trifluoromethanesulfonate,
2,4,6-trimethylphenyldiphenylsulfonium trifluoromethanesulfonate,
4-tert-butylphenyldiphenylsulfonium trifluoromethanesulfonate,
4-phenylthiophenyldiphenylsulfonium hexafluorophosphate,
4-phenylthiophenyldiphenylsulfonium hexafluoroantimonate,
1-(2-naphthoylmethyl)thiolanium hexafluoroantimonate,
1-(2-naphthoylmethyl)thiolanium trifluoromethaneuslfonate,
4-hydroxy-1-naphthyldimethylsulfonium hexafluoroantimonate and
4-hydroxy-1-naphthyldimethylsulfonium trifluoromethanesulfonate.

Examples of the halogen-containing triazine compound represented by the formula (III) include:
2-methyl-4,6-bis(trihcloromethyl)-1,3,5-triazine,
2,4,6-tris(trichloromethyl)-1,3,5-triazine,
2-phenyl-4,6-bis(trichloromethyl)-1,3,5-triazine,
2-(4-chlorophenyl)-4,6-bis(trichloromethyl)-1,3,5-triazine,
2-(4-methoxyphenyl)-4,6-bis(trichloromethyl)-1,3,5-triazine,
2-(4-methoxy-1-naphthyl)-4,6-bis(trichloromethyl)-1,3,5-triazine,
2-(benzo[d][1,3]dioxolane-5-yl)-4,6-bis(trichloromethyl)-1,3,5-triazine,
2-(4-methoxystyryl)-4,6-bis(trichloromethyl)-1,3,5-triazine,
2-(3,4,5-trimethoxystyryl)-4,6-bis(trichloromethyl)-1,3,5-triazine,
2-(3,4-dimethoxystyryl)-4,6-bis(trichloromethyl)-1,3,5-triazine,
2-(2,4-dimethoxystyryl)-4,6-bis(trichloromethyl)-1,3,5-triazine,
2-(2-methoxystyryl)-4,6-bis(trichloromethyl)-1,3,5-triazine,
2-(4-butoxystyryl)-4,6-bis(trichloromethyl)-1,3,5-triazine and
2-(4-pentyloxystyryl)-4,6-bis(trichloromethyl)-1,3,5-triazine.

Examples of the sulfone compound represented by the formula (IV) include:
diphenyl disulfone,
di-p-tolyl disulfone,
bis(phenylsulfonyl)diazomethane,
bis(4-chlorophenylsulfonyl)diazomethane,
bis(p-trisulfonyl)diazomethane,
bis(4-tert-butylphenylsulfonyl)diazomethane,
bis(2,4-xylylsulfonyl)diazomethane,
bis(cyclohexylsulfonyl)diazomethane,
(benzoyl)(phenylsulfonyl)diazomethane and
phenylsulfonylacetophenone.

Examples of the sulfonate compound represented by the formula (V) include:
α-benzoylbenzyl p-toluenesulfonate (commonly called benzoinetosylate),
β-benzoyl-β-hydroxyphenetyl p-toluenesulfonate (commonly called α-methylolbenzoinetosylate),
1,2,3-benzenetoriyl trismethanesulfonate,
2,6-dinitrobenzyl p-toluenesulfonate,
2-nitrobenzyl p-toluenesulfonate and
4-nitrobenzyl p-toluenesulfonate.

Examples of the sulfonate compound of N-hydroxyimide represented by the formula (VI) include:
N-(phenylsulfonyloxy)succinimide,
N-(trifluoromethylsulfonyloxy)succinimide,
N-(p-chlorophenylsulfonyloxy)succinimide,
N-(cyclohexylsulfonyloxy)succinimide,
N-(1-naphthylsulfonyloxy)succinimide,
N-(benxylsulfonyloxy)succinimide,
N-(10-camphorsulfonyloxy)succinimide,
N-(trifluoromethylsulfonyloxy)phthalimide,
N-(trifluoromethylsulfonyloxy)-5-norbornene-2,3-dicarboxyimide,
N-(trifluoromethylsulfonyloxy)naphthalimide and
N-(10-camphorsulfonyloxy)naphthalimide.

Some of the above-described light acid generators which are thermally unstable and are decomposed at a relatively low temperature from about 110 to 150°C can be used also as a heat acid generator, which generates an acid by heat decomposition. A compound which has no sensitivity against a light but generate an acid by heating can also be used as a heat acid generator.

Some of acid growing agents described in JP-A-8-248561 which are thermally unstable and are decomposed at a relatively low temperature as described-above can be used as a heat acid generator. Esters of a perfluoroalkylsulfonic acid or perfluoroalkylcarboxylic acid can also be used as a heat acid generator since they generate acid by heating at a relatively low temperature as described-above. Some other acid growing agents described in JP-A-8-248561 which are not decomposed themselves by a light or heat can be combined with an acid generating agent which is decomposed by light or heat for the purpose of enhancing acid generation efficiency and improving heat setting property.

As the radical generator which generates a radical by heat decomposition, various compound known as initiators for radical reaction such as peroxides and azo compounds which are decomposed at a relatively low temperature from about 110 to 150°C can be used.

It is preferred that the positive resist composition herein used further comprises a cross-linking agent in addition to the above-described novolak resin, quinonediazide-based radioactive ray-sensitive agent and active agent. Then, the present invention also provide a positive resist composition comprising an alkali-soluble novolak resin, a quinonediazide-based radioactive ray-sensitive agent, an active agent which has no sensitivity against the wavelength of patterning exposure but generates an acid or radical by the following treatment, and a cross-linking agent.

Any cross-linking agents which allow a novolak resin to be cross-linked and cured, such as those used in general resin field negative resist field, fiber treating agent field and the like, may be used herein. Specifically, epoxy compounds, compounds having a methylol group or methylol ether group, and the like may be listed. Examples of the epoxy-based cross-linking agent include low molecular weight phenol compounds, such as bisphenol A, and a novolak resin oligomer, in which the phenolic hydroxyl groups are glycidyl-etherified.

Examples of the cross-linking agent having a methylol group or methylol ether group include melamine or guanamine-based compounds represented by the following formula (VII): 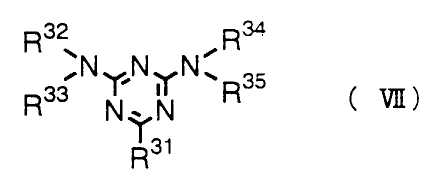 wherein, A³¹ represents -NR³⁶R³⁷ or aryl, and when R³¹ represents -NR³⁶R³⁷, one of R³², R³³, R³⁴, R³⁵, R³⁶ and R³⁷ represents -CH₂OR³⁸ and when R³¹ represents aryl, one of R³², R³³, R³⁴ and R³⁵ represents -CH₂OR³⁸, and the remaining groups of R³², R³³, R³⁴, R³⁵, R³⁶ and R³⁷ each independently represents hydrogen or -CH₂OR³⁸, wherein R³⁸ represents hydrogen or alkyl.

The aryl group in the formula (VII) is generally phenyl, 1-naphthyl or 2-naphthyl which may optionally be substituted with a substituent such as alkyl, alkoxy and halogen. Generally, the alkyl and alkoxy have about 1 to 6 carbon atoms respectively. The alkyl represented by R³⁸ is generally methyl or ethyl, particularly methyl.

Examples of the melamine-based compound represented by the formula (VII), namely compound represented by the following formula (VIIa): 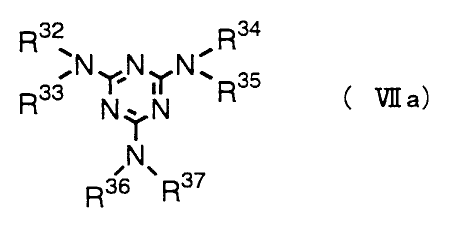 wherein, R³², R³³, R³⁴, R³⁵, R³⁶ and R³⁷ have the meanings as described above
include hexamethylolmelamine, pentamethylolmelamine, tetramethylolmelamine, hexamethoxymethylmelamine, pentamethoxymethylmelamine, tetramethoxymethylmelamine and hexaethoxymethylmelamine.

Examples of the guanamine-based compound represented by the formula (VII) include tetramethylolbenzoguanamine, tetramethoxymethylbenzoguanamine, trimethoxymethylbenzoguanamine and tetraethoxymethylbenzoguanamine.

Examples of the cross-linking agent having a methylol group or methylol ether group further includes:
(a) 2,6-bis(hydroxymethyl)-4-methylphenol
(b) 4-tert-butyl-2,6-bis(hydroxymethyl)phenol,
(c) 5-ethyl-1,3-bis(hydroxymethyl)perhydro-1,3,5-triazine-2-one (commonly called N-ethyldimethyloltriazine) or dimethyl ether body thereof,
(d) dimethyloltrimethyleneurea or dimethyl ether body thereof,
(e) 3,5-bis(hydroxymethyl)perhydro-1,3,5-oxadiazine-4-one (commonly called dimethylolurone) or dimethyl ether body thereof, and
(f) tetramethylolglyoxaldiureine or tetramethyl ether body thereof.

Chemical structures of the examples (a) - (b) and chemical structures of the methyl ether bodies of the examples (c) - (f) are shown below.

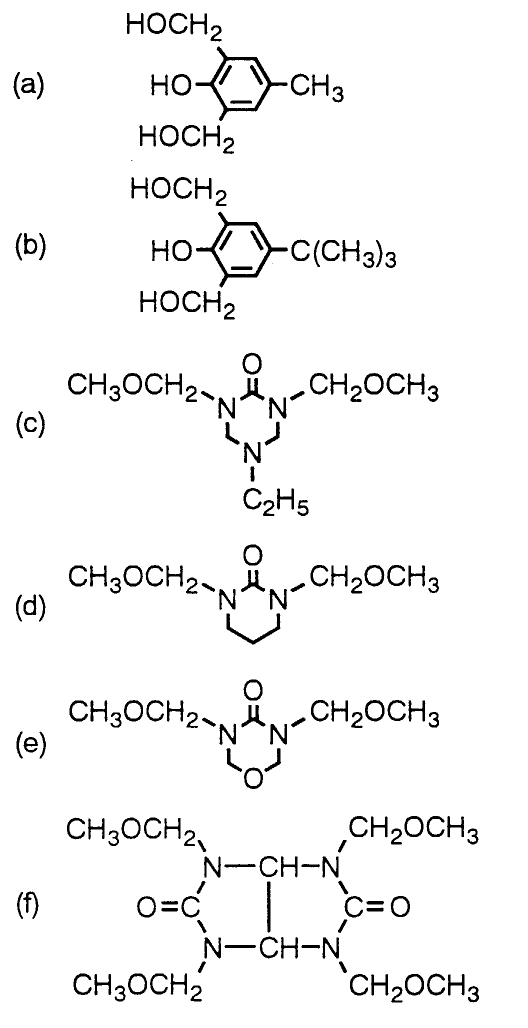

When the positive resist composition (A) comprises an active agent and a cross-linking agent, the active agent and the cross-linking agent are used in sufficient amount for effecting action as described above. In general, amount of the active agent is preferably from about 0.1 to 25% by weight and amount of the cross-linking agent is preferably about 30% by weight or less, more preferably from 0.1 to 30% by weight, based on the total amount of solid components in the resist composition. When the amount of the active agent or the cross-linking agent is too small, the effect of the present invention may become insufficient. On the other hand, when the amount is too large, basic properties such as resolution may be unfavorably influenced. When the active agent is alkali-insoluble, if the amount thereof is too large, the sensitivity tends to be decreased.

In the method of the present invention in which irradiation with a light having wavelength shorter than that used for the patterning exposure and heating for allowing the resist pattern to swell are conducted, image part of a resist (remaining part as a resist film) is allowed to swell in high dimension accuracy by irradiating the whole pattern after alkaline development and heating, and consequently, a fine hole pattern can be formed. It is also effective to heat the resist pattern for curing to some extent at temperature which does not cause swelling before the heating for swelling and curing the image part.

A positive resist composition (B) may also contain a cross-linking agent in addition to an alkaline-soluble novolak resin and a quinonediazide-based radioactive ray-sensitive agent if required. Curing by heating progresses more effectively by the cross-linking agent. Particularly, when a resist pattern is cured by heating at temperature which does not case swelling of the resist pattern before heating at temperature sufficient for swelling the resist pattern, the existence of a cross-linking agent may sometimes be advantageous.

Same cross-linking agents as those mentioned above are used.

Amount of the cross-linking agent is usually in the range of 10% by weight or less, preferably of 0.01% by weight or more and 1% by weight or less.

The positive resist composition (A) or the positive resist composition (B) is usually dissolved in a solvent to prepare a resist solution which is coated on a substrate such as silicon wafer. A solvent which dissolves the components, has suitable drying speed, and gives a uniform and smooth coated film after vaporization of the solvent can be used for the positive resist composition (A) and (B). Solvents usually used in this field can be used for the positive resist composition (A) and (B).

Examples thereof include glycol ether esters such as ethylcellosolve acetate, methylcellosolve acetate, propylene glycol monomethyl ether acetate and propylene glycol monoethyl ether acetate, glycol ethers such as ethylcellosolve, methylcellosolve, propylene glycol monomethyl ether and propylene glycol monoethyl ether, esters such as ethyl lactate, butyl acetate, amyl acetate and ethyl pyruvate, ketones such as 2-heptanone and cyclohexanone, and cyclic esters such as γ-butyrolactone. These solvents can be used respectively alone or in combination of two or more. The positive resist composition (A) and (B) may also comprise a small amount of additives commonly used in this field such as resins other than novolak resins and dyes according to demands. The positive resist composition (A) and (B) may further comprise a resolution improving agent such as thioxanetones, which is proposed in JP-A-10-152735. Total amount of the other additives mentioned above is 3 % by weight or less based on the total solid content in the resist composition.

The positive resist composition (A) or (B) is coated on a substrate to form a resist film, which is then subjected to patterning exposure through a mask. For this patterning exposure, a visual light or a near ultraviolet ray such as g-line (436 nm) and i-line (365 nm) is usually used. After the patterning exposure, the resist film is developed with an alkaline developer. The alkaline developer may be selected from various aqueous alkaline solution used in this field. Aqueous solution of tetramethylammonium hydroxide or (2-hydroxyethyl)trimethylammonium hydroxide (commonly called choline) is commonly used as the developer.

In the method of the present invention in which a positive resist composition (A) is used, after the development, an acid or radical is generated from the active agent existing in the resist and curing is conducted by heating. When the active agent is a light acid generator, the whole pattern is irradiated with a light having wavelength against which the light acid generator has sensitivity to generate an acid. Herein, the wavelength against which the light acid generator has sensitivity means a wavelength at which the light acid generator is decomposed to generate an acid by the action of the light. For the irradiation, any light source having a wavelength at which the light acid generator is decomposed can be used. However, the light used for irradiating whole pattern to generate an acid is preferably has wavelength shorter than that of patterning exposure.

Examples of the light source used for this irradiation include a XeCl excimer lamp having a wavelength of 308 nm, bright line of a mercury lamp having a wavelength of 254 nm, a KrF excimer laser light having a wavelength of 248 nm, a KrCl excimer lamp having a wavelength of 222 nm, a ArF excimer laser light having a wavelength of 193 nm, bright line of a mercury lamp having a wavelength of 185 nm and a Xe₂ excimer lamp having a wavelength of 172 nm. In general, deep UV having a wavelength of 300 nm or less is preferred.

If a cross-linking agent exists in the treatment wherein an acid generates from the light acid generator and a novolak resin is cured by heating, the generated acid acts on the cross-linking agent and makes the curing more effectively. Temperature and time for heating is selected so that the cross-linking and curing progress. In general, heating is conducted at a temperature from about 110 to 180°C for 0.5 to 10 minutes. Usually, it is preferred that heating is conducted after the generation of acid from a light acid generator by the irradiation. However, heating may be conducted while irradiating a light to generate an acid.

Further, when the above-described reflow treatment is conducted, the heating treatment may also be utilized simultaneously as heating in the reflow process. The heating treatment may be conducted in one-step process at relatively higher temperature in the above-described temperature range, for example from 140 to 180°C, or in two-step process in which heating is first conducted at lower temperature and then at higher temperature.

When the active agent is a heat acid generator or a radical generator, an acid or radical is generated by heating. Temperature and time for heating is selected so that the heat acid generator or radical generator is decomposed to generate an acid or radical. In general, a temperature from about 110 to 180°C is adopted and a heat acid generator or radical generator which is decomposed at this temperature is preferably used. The heating treatment for generating an acid or radical for curing may be conducted in one-step process at a temperature in the above-described temperature range. It is also effective to adopt two-step heating process in which a compound which is decomposed at a relatively lower temperature, for example from 110 to 150°C, is used as the heat acid generator or radical generator, and an acid or radical is generated by first heating at the relatively lower temperature and then curing to cure the resist is conducted by heating at sufficiently higher temperature. For example, a heat acid generator or radical generator which is decomposed at a temperature of 110°C or more, preferably from about 110 to 150°C, is used, and heating treatment is conducted for generating an acid or radical at a temperature in the above-described range, then curing by heating is conducted at a temperature which is in the range from about 140 to 180°C and higher than the temperature of former heating.

When reflow treatment is conducted, this heating treatment can also be utilized simultaneously as heating in the reflow treatment.

In the method of the present invention in which irradiation with a light having wavelength shorter than that used for the patterning exposure and heating for allowing the resist pattern to swell are conducted, the whole resist pattern after development is irradiated with a light having wavelength shorter than that used for the patterning exposure. Examples of the light source used for this irradiation include a XeCl excimer lamp having a wavelength of 308 nm, bright line of a mercury lamp having a wavelength of 254 nm, a KrF excimer laser light having a wavelength of 248 nm, a KrCl excimer lamp having a wavelength of 222 nm, a ArF excimer laser light having a wavelength of 193 nm, bright line of a mercury lamp having a wavelength of 185 nm and a Xe₂ excimer lamp having a wavelength of 172 nm. In general, deep UV having a wavelength of 300 nm or less is preferred.

After the whole surface exposure onto a developed pattern, so-called reflow treatment is conducted in which a resist pattern is allowed to swell and a hole pattern is allowed to contract. This heat treatment is conducted at temperature sufficient for swelling of the resist pattern, and a temperature usually of 140°C or more, particularly from about 140 to 180°C is adopted though it slightly varies depending on the kind of the resist, particularly on the combination of an alkaline-soluble component with a quinonediazide-based radioactive ray-sensitive agent.

As described above, it is also effective that a pattern after development is subjected to the whole surface exposure, then, the resist pattern is heated for curing to some extent at temperature which does not cause swelling of it, and subsequently the resist pattern is heated at temperature sufficient for allowing it to swell. Such temperature at which the resist pattern does not swell also varies slightly depending on the kind of the resist, and is usually from about 110 to 140°C. The heating at which the resist pattern does not swell is usually conducted for about 0.5 to 5 minutes. Whether the treatment in which the resist pattern is heated at temperature at which it does not swell is inserted halfway or not inserted, the heat treatment at temperature sufficient for swelling of the resist pattern is usually conducted for about 0.5 to 5 minutes.

### EXAMPLE

The following examples further illustrate the present invention in detail, but do not limit the scope thereof. In the examples, "%" and "parts" are by weight unless otherwise stated. The weight-average molecular weight is measured from GPC using a polystyrene as a standard.

Main materials used in Examples 1-10 and Comparative Examples 1-6 are described below.

### (a) Novolak resin

Obtained by reacting m-cresol/p-cresol/formaldehyde in a molar ration of 50/50/80 in the presence of a oxalic acid catalyst under reflux according to a normal method, followed by fractionation.

weight-average molecular weight in terms of polystyrene weight is about 8,000.

In GPC pattern, the area ratio of compounds having a molecular weight in terms of polystyrene of 6,000 or less is 34%, and the area ratio of compounds having a molecular weight in terms of polystyrene of 1,000 or less is 15% based on the total pattern area excepting the pattern area of unreacted cresol.

### (b) Quinonediazide-based light sensitive agent

A condensate of 2,4,4-trimethyl-2',4',7-trihydroxyflavan having a structure represented by the following formula: 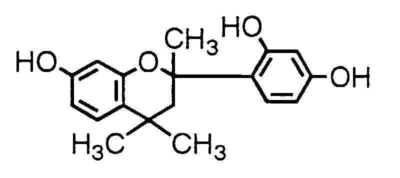 with 1,2-naphthoquinonediazide-5-sulfonic acid chloride in a reaction molar ration of 1:2.6.

### (c) Active agent

Light acid generator C1: N-(10-camphorsulfonyloxy)succinimide
Heat acid generator C2: Benzoin tosylate
Heat acid generator C3: 2-nitrobenzyl tosylate ("NB-101" manufactured by Midori Kagaku K.K.)
Heat acid generator C4: 2-hydroxy-2-methylcyclohexyl tosylate Radical generator C5: 2,2'-azobis(iso butyric acid)dimethyl

These active agents respectively have structures of the following formulae.

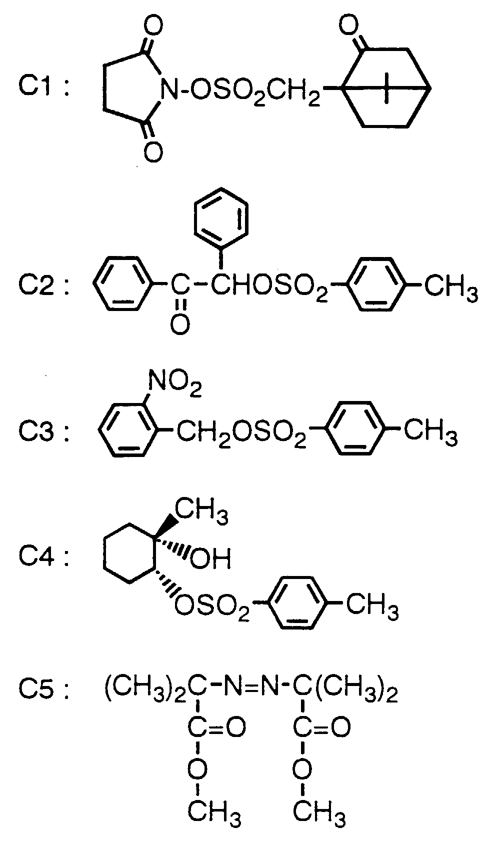

### (d) Cross-linking agent

Cross-linking agent D1: hexamethoxymethylmelamine

### Examples 1 to 6 and Comparative Examples 1 to 4

11 parts of the above-described novolak resin, 4 parts of the above-described quinonediazide-based light sensitive agent, 4 parts of 4,4'-(2-hydroxybenzilidene)di-2,6-xylenol as an additive and 45 parts of 2-heptanone as a solvent were mixed. To the solution thus obtained were added each of light acid generators and each of cross-linking agents shown in Table 1, dissolved and, then, filtered through a 0.2 µm fluorine resin filter to prepare resist solutions.

On a silicone wafer treated with hexamethyldisilazane (HMDS), each of the resist solutions obtained above was spin-coated so that the thickness after drying became 1.28 µm. Pre-baking was conducted on a direct hot plate under conditions of 90°C for 60 seconds. The wafers on which resist films had been thus formed were exposed using a g-line stepper manufactured by Nikon Corp. ("NSR-1755g7A", NA=0.54) or an i-line stepper manufactured by the same company ("NSR-2005i9C", NA=0.57, σ=0.60) with gradually changing exposure amount to form line and space patterns having various dimensions. Then, post-exposure-baking was conducted on a hot plate under conditions of 110°C for 60 seconds, and subsequently, paddle development was conducted using an aqueous 2.38% by weight tetramethylammonoiumhydroxide solution for 30 seconds.

The wafers after development were closely contacted to an irradiation window of an exicimer lamp ["UER-20-172" (wavelength 172nm) or "URE-20-222" (wavelength 222 nm)] manufactured by Ushio Inc., and exposed under conditions shown in Table 1. When "UER-20-172" was used, illumination intensity at the irradiation window was 10 mW/cm². Then, the wafers were put on hot plates set at various temperatures, heated for 180 seconds and heat resistance tests were conducted. The patterns before and after the heating were observed by a scanning type electron microscope. Effective sensitivity and resolution were evaluated as shown below regarding patterns before the heating, and heat resistance was evaluated as shown below regarding patterns after the heating, and the results are shown in Table 1.
Effective sensitivity: expressed by exposure amount at which cross section of 0.60 µm line and space pattern was 1:1.
Resolution: expressed by the minimum line width of line and space pattern which was separated at the exposure amount of the effective sensitivity.

Heat resistance: expressed by temperature at which 3 µm line and space pattern which had been exposed at the effective sensitivity and developed initiated deformation.

**Table 1**

| Example No. | Light acid genorator | Cross-linking agent | Patterning wavelength | Exposure after development | | Effective sensitivity (msec) | Resolution (µm) | Heat resistance (°C) |
|---|---|---|---|---|---|---|---|---|
| | | | | wavelength (nm) | Times (sec) | | | |
| Example 1 | C1/0.5 parts | None | g-line | 172 | 10 | 700 | 0.45 | 180 |
| Example 2 | C1/0.5 parts | D1/0.1 parts | g-line | 172 | 10 | 700 | 0.45 | >180 |
| Example 3 | C1/0.5 parts | D1/1.0 parts | g-line | 172 | 10 | 700 | 0.45 | >180 |
| Example 4 | C1/0.5 parts | D1/1.0 parts | g-line | 172 | 100 | 700 | 0.45 | >180 |
| Example 5 | C1/0.5 parts | D1/1.0 parts | i-line | 172 | 10 | 450 | 0.40 | >180 |
| Example 6 | C1/0.5 parts | D1/1.0 parts | g-line | 222 | 10 | 700 | 0.45 | >180 |
| Comparative example 1 | None | None | g-line | No exposure | | 700 | 0.45 | 140 |
| Comparative example 2 | C1/0.5 parts | None | g-line | No exposure | | 700 | 0.45 | 140 |
| Comparative example 3 | C1/0.5 parts | D1/1.0 parts | g-line | No exposure | | 700 | 0.45 | 140 |
| Comparative example 4 | None | None | g-line | 172 | 100 | 700 | 0.45 | 160 |

In Comparative Example 1, a pattern is formed using a conventional resist according to a conventional method. In Examples 1 to 6, a resist film comprising a light acid generator is subjected to patterning exposure, developed, then, irradiated with a light having wavelength by which the light acid generator is decomposed to generate an acid, then heated, according to a method of the present invention. Comparing to Comparative Example 1, heat resistance is remarkably improved without lowering sensitivity and resolution in Examples 1-6. In this procedure, it is further effective that a cross-linking agent is comprised together with the light acid generator as shown in comparison with Example 1 and Example 2-6. On the other hand, even if a light acid generator is comprised as in Comparative Example 2 or a light acid generator and cross-linking agent are comprised as in Comparative Example 3, no improvement in heat resistance was observed when exposure is not conducted after development. It is supposed that this is because curing by cross-linking did not progress since no acid was generated from the light and acid generator. When resist composition is conventional one and exposure after development is conducted as in Comparative Example 4, heat resistance is slightly improved. However, the compositions according to Examples 1 to 6 exhibited further improved heat resistance in comparison with that of Comparative Example 4.

### Examples 7 to 10 and Comparative Examples 5 to 6

11 parts of the above-described novolak resin, 4 parts of the above-described quinonediazide-based light sensitive agent, 4 parts of 4,4'-(2-hydroxybenzilidene)di-2,6-xylenol as an additive and 45 parts of 2-heptanone as a solvent were mixed. To this solution were added active agents (heat acid generator or radical generator) and cross-linking agents shown in Table 2, dissolved and, then, filtered through a 0.2 µm fluorine resin filter to prepare resist solutions.

On a silicone wafer treated with hexamethyldisilazane (HMDS), the resist solutions obtained above were spin-coated so that the thickness after drying became 1.28 µm. Pre-baking was conducted on a direct hot plate under conditions of 90°C for 60 seconds. The wafers on which resist films had been thus formed were exposed using a g-line stepper manufactured by Nikon Corp. ("NSR-1755g7A", NA=0.54) with gradually changing exposure to form line and space patterns having various dimensions. Then, post-exposure-baking was conducted on a hot plate under conditions of 110°C for 60 seconds, and subsequently, paddle development was conducted using an aqueous 2.38% by weight tetramethylammonoiumhydroxide solution for 30 seconds.

The wafers after development were heated on a hot plate of 130°C for 180 seconds. Then, they were put on hot plates set at various temperatures, heated for 180 seconds and heat resistance tests were conducted. The patterns before and after the heating were observed by a scanning type electron microscope. Effective sensitivity, resolution and heat resistance were evaluated in the same manners as in Examples 1 - 6, and the results are shown in Table 2.

**Table 2**

| Example No. | Heat acid generator or radical generator | Cross-linking agent | Effective sensitivity (msec) | Resolution (µm) | Heat resistance (°C) |
|---|---|---|---|---|---|
| Example 7 | C2/0.1 parts | D1/0.1 parts | 700 | 0.45 | >180 |
| Example 8 | C3/0.1 parts | D1/0.1 parts | 700 | 0.45 | >180 |
| Example 9 | C4/0.1 parts | D1/0.1 parts | 700 | 0.45 | >180 |
| Example 10 | C5/0.1 parts | D1/0.1 parts | 700 | 0.45 | >180 |
| Comparative example 5 | None | None | 700 | 0.45 | 140 |
| Comparative example 6 | None | D1/0.1 parts | 700 | 0.45 | 140 |

In Comparative Example 5, a pattern is formed using a conventional resist according to a conventional method In Examples 7 - 10, a resist film comprising a heat acid generator or radical generator is subjected to patterning exposure, developed, then, heated at temperature at which the heat acid generator or radical generator is decomposed to generate an acid, according to a method of the present invention. Comparing to Comparative Example 5, heat resistance is remarkably improved without lowering sensitivity and resolution in Examples 7 - 10. On the other hand, even if a cross-linking agent is comprised as in Comparative Example 6, no improvement was observed in heat resistance when a heat acid generator and radical generator are not comprised. It is supposed that this is because curing by cross-linking did not progress since no acid or radical was generated from the heat acid generator and radical generator.

### Reference Example 1 (Production of Novolak resin)

Into a reaction vessel was charged 479.7 parts of m-/p-mixed cresol containing 62% of m-cresol, 115.1 parts of p-cresol, 268.75 parts of 2,5-xylenol, 39.3 parts of oxalic acid dihydrate, 261.8 parts of a 90% aqueous acetic acid solution and 803.1 parts of methyl isobutyl ketone, and the mixture was heated to 80°C. To this was added 463.2 parts of 37% formalin over 30 minutes, and the mixture was further heated and reacted for 13 hours while maintaining reflux condition at 92°C. After completion of the reaction, 486.2 parts of methyl isobutyl ketone was charged, then, 1823.2 parts of water was added for washing and the mixtures was separated. This washing and separation procedure was repeated six times. After completion of the washing procedure, the oil layer was concentrated to obtain a methyl isobutyl ketone solution of a novolak resin. This resin had a weight average molecular weight of about 4,400. To this solution was added methyl isobutyl ketone to dilute the solution to 20% concentration. To 400 parts of this 20% solution was added 545.2 parts of n-heptane while stirring. The resulted mixture was further stirred for 30 minutes at 60°C, then, allowed to stand still for separation. 76.3 parts of the resulted lower layer was diluted with 400 parts of 2-heptanone, then, concentrated to obtain 109.7 parts of a 2-heptanone solution of a novolak resin. This novolak resin is referred to as Resin A. This resin had a weight average molecular weight of about 7,200, and in this resin, the area ratio corresponding to a molecular weight of 1,000 or less in GPC pattern was about 20%.

### Reference Example 2 (Production of other novolak resin)

Into a reaction vessel was charged 486.6 parts of m-cresol, 219.6 parts of 2,5-xylenol, 31.8 parts of oxalic acid dihydrate, 214.2 parts of a 90% aqueous acetic acid solution and 635.0 parts of methyl isobutyl ketone, and the mixture was heated to 80°C. To this mixture was added 450.9 parts of 37% formalin over 30 minutes, and the mixture was further heated and reacted for 11 hours while maintaining reflux condition at 92°C. After completion of the reaction, 461.5 parts of methyl isobutyl ketone was charged. Then, 1500 parts of water was added for washing and the mixtures was separated. This washing and separation procedure was repeated six times. After completion of the washing procedure, the oil layer was concentrated to obtain a methyl isobutyl ketone solution of a novolak resin. This resin had a weight average molecular weight of about 4,800. To this solution was added methyl isobutyl ketone to dilute the solution to 22% concentration. To 400 parts of this 22% solution was added 271.2 parts of n-heptane while stirring. The resulted mixture was further stirred for 30 minutes at 60°C, then, allowed to stand still for separation. 91.4 parts of the resulted lower layer was diluted with 400 parts of 2-heptanone, then, concentrated to obtain 135.8 parts of a 2-heptanone solution of a novolak resin. This novolak resin is referred to as Resin B. This resin had a weight average molecular weight of about 6,100. In this resin, the area ratio corresponding to a molecular weight of 1,000 or less in GPC pattern was about 20%.

### Experiment Examples 1 to 16

2.5 parts, in terms of the weight of a solid component, of the novolak resin A obtained according to the same method as in Reference Example 1, 7.5 parts, in terms of the weight of a solid component, of the novolak resin B obtained according to the same method as in Reference Example 2, 6 parts of a condensate of 2,6-bis[4-hydroxy-3-(2-hydroxy-5-methylbenzyl)-2,5-dimethylbenzyl]-4-methylphenol, having a structure represented by the following formula: 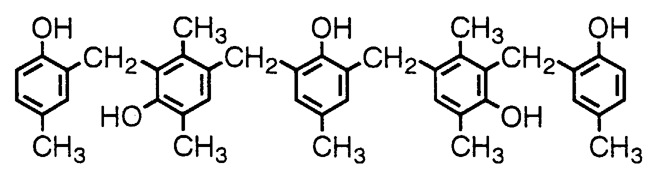 with 1,2-naphthoquinonediazide-5-sulfonic acid chloride in a reaction molar ratio of 1:2.2, as a radioactive ray-sensitive agent, 4.3 parts of 1,1-bis(4-hydroxyphenyl)cyclohexane ("Bisphenol Z" manufactured by Honshu Chemical Industry Co., Ltd.) as an additive, 0.3 parts of a mixture of 2-isopropylthioxanetone and 4-isopropylthioxanetone ("SPEED CURE ITX" manufactured by LAMBSON) as a resolution improving agent and 2-heptanone as a solvent were mixed so that the total amount of 2-heptanone was 45 parts including 2-heptanone from the novolak resin. In Experiment Examples 9 - 16, 0.1 part of hexamethoxymethylmelamine was further added as a cross-linking agent. These solution thus obtained were filtered through a 0.2 µm fluorine resin filter to prepare resist solutions.

On a silicone wafer treated with hexamethyldisilazane (HMDS), the resist solutions obtained above were spin-coated so that the thickness after drying became 0.79 µm. Pre-baking was conducted on a direct hot plate under conditions of 90°C for 60 seconds. The wafers on which resist films had been thus formed were exposed through a half tone mask of which mask part has a transmission of 8% using a i-beam stepper manufactured by Nikon Corp. ("NSR-2005i9C", NA=0.57, σ=0.4) with gradually changing exposure time to form a hole pattern. The mask used allows exposure of 0.35 µm square hole 1 on a resist under optimum exposure conditions as shown in Fig. 1. The exposed part is removed by development, and the surrounding unexposed parts remains as an image 2 to give a pattern, wherein ratio of the width of the hole 1 to the interval between the holes (a:b, Duty ratio) is 1:2. However, due to 0.05 µm mask bias, the size of bottom surface of the obtained hole pattern was 0.30 µm. (This means the exposure time was somewhat shorter than the optimum exposure time.)

Then, post-exposure-baking was conducted on a hot plate under conditions of 110°C for 60 seconds, and subsequently, paddle development was conducted using an aqueous 2.38% tetramethylammonoiumhydroxide solution for 60 seconds. Then, the square hole pattern having a size of the hole bottom surface of 0.30 µm was examined as described below. The exposure time was 590 milliseconds in Experiment Examples 1 - 8 and 560 milliseconds in Experiment Examples 9 - 16.

The wafers after development were closely contacted to an irradiation window of an exicimer lamp ["UER-20-222" (wavelength 222 nm)] manufactured by Ushio Inc., and exposed for 30 seconds. The illumination intensity at the irradiation window is 7 mW/cm² according to catalogue value given by the manufacturer. Then, the wafers were put on hot plates set at various temperatures, heated for 60 seconds and reflow was conducted. The patterns after the reflow were observed by a scanning type electron microscope, the sizes of the hole bottom surfaces were measured, and the results are shown in Table 3.

**Table 3**

| Ex.Example No. | Cross-linking agent | 222 nm exposure | Reflow temperature | Hole size |
|---|---|---|---|---|
| 1 | Not used | Conducted | No heating | 0.30 µm |
| 2 | " | " | 130°C | 0.30 µm |
| 3 | " | " | 140°C | 0.24 µm |
| 4 | " | " | 150°C | 0.18 µm |
| 5 | " | Not conducted | No heating | 0.30 µm |
| 6 | " | " | 130°C | 0.30 µm |
| 7 | " | " | 140°C | Hole was clogged |
| 8 | " | " | 150°C | Hole was clogged |
| 9 | Used | Conducted | No heating | 0.30 µm |
| 10 | " | " | 130°C | 0.30 µm |
| 11 | " | " | 140°C | 0.23 µm |
| 12 | " | " | 150°C | 0.14 µm |
| 13 | " | Not conducted | No heating | 0.30 µm |
| 14 | " | " | 130°C | Hole was clogged |
| 15 | " | " | 140°C | Hole was clogged |
| 16 | " | " | 150°C | Hole was clogged |

As shown in Table 1, when exposure is conducted (Experiment Examples 2 - 4 and 10 - 12), variation in dimension due to change in reflow temperature is mild, and dimension control property is excellent. By conducting reflow at suitable temperature, 140°C or more in these examples, an extremely fine hole pattern can be formed.

According to the method of the present invention in which a positive resist composition comprising an active agent, that is, a positive resist composition A, is used, heat resistance can be remarkably improved without lowering various abilities such as sensitivity and resolution. Therefore, reliability in ion implantation is enhanced, and the composition can be effectively used for reflow treatment and the like.

According to the method of the present invention in which irradiation on the resist pattern whole surface after development with a light having wavelength shorter than that used for the patterning exposure and heating for allowing the resist pattern to swell are conducted, the dimension control property in the following heat reflow is improved to obtain a fine hole pattern. That is, by appropriately setting heating temperature (reflow temperature) and by simple operation, reflow treatment which allows a resist pattern to swell with high dimension accuracy can be conducted, and consequently, an extremely fine pattern can be formed.

## Claims

1. A method for forming a resist pattern which comprises coating a positive resist composition comprising an alkali-soluble novolak resin, a quinonediazide-based radioactive ray-sensitive agent, and an active agent which has no sensitivity against the wavelength of patterning exposure but is able to generate an acid or a radical on a substrate to form a resist film; subjecting the resist film to patterning exposure; conducting a development with an alkaline developer; and generating an acid or radical from the active agent for curing.

2. The method according to Claim 1, wherein the active agent is a light acid generator which has no sensitivity against the wavelength of patterning exposure but has sensitivity against a light of other wavelength, and an acid is generated from the light acid generator by irradiation of a light having wavelength against which the light acid generator has sensitivity and heating.

3. The method according to Claim 2, wherein the patterning exposure is conducted using g-line of 436 nm or i-line of 365 nm, and the irradiation of a light after development is conducted using a light having wavelength shorter than that of said patterning exposure.

4. The method according to Claim 1, wherein the active agent is a heat acid generator which generates an acid by heating.

5. The method according to Claim 4, wherein after generating an acid from the heat acid generator by heating, further heat treatment is conducted for curing.

6. The method according to Claim 1, wherein the active agent is a radical generator which generates a radical by heating.

7. The method according to Claims 2, 4 or 6, wherein the heating is conducted at a temperature from 110 to 180°C.

8. The method according to Claim 1, wherein the positive resist composition further comprises a cross-linking agent.

9. A positive resist composition comprising an alkali-soluble novolak resin, a quinonediazide-based radioactive ray-sensitive agent, an active agent which has no sensitivity against the wavelength of patterning exposure but is able to generate an acid or radical, and a cross-linking agent.

10. The composition according to Claim 9, wherein the active agent is a light acid generator which has no sensitivity against the wavelength of patterning exposure but has sensitivity against a light having wavelength shorter than the wavelength of patterning exposure.

11. The composition according to Claim 9, wherein the active agent is a heat acid generator which generates an acid by heating.

12. The composition according to Claim 9, wherein the active agent is a radical generator which generates a radical by heating.

13. The composition according to Claim 9, wherein the cross-linking agent is a melamine compound represented by the following formula (VIIa): 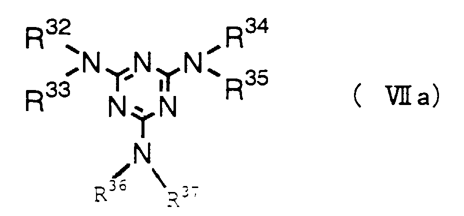 wherein, one of R³², R³³, R³⁴, R³⁵, R³⁶ and R³⁷ represents -CH₂OR³⁸ and the remaining groups of them each independently represents hydrogen or -CH₂OR³⁸, wherein R³⁸ represents hydrogen or an alkyl.

14. The composition according to any of Claims 9, wherein the active agent is comprised in an amount from 0.1 to 25% by weight and the cross-linking agent is comprised in an amount from 0.1 to 30% by weight based on the total amount of solid components in the composition.

15. A method for forming a resist pattern which comprises coating a positive resist composition comprises an alkaline-soluble novolak resin and a quinonediazide-based radioactive ray-sensitive agent on a substrate to form a resist film; subjecting the resist film to patterning exposure; conducting development with an alkaline developer; irradiating the resist pattern thus obtained with a light having wavelength shorter than that used for the patterning exposure; and then heating the irradiated pattern at temperature sufficient for allowing the resist pattern to swell to obtain a resist pattern in which the area of part from which a resist is removed is contracted.

16. The met-ad according to Claim 15, wherein the positive resist composition further comprises a cross-linking agent.

17. The method according to Claim 15, wherein the patterning exposure is conducted using g-line of 436 nm or i-line of 365 nm, and the irradiation of a light after development is conducted using a ultra-violet ray having wavelength of 300 nm or shorter.

18. The method according to Claim 15, wherein, after irradiation with a light having wavelength shorter than that used for the patterning exposure, the resist pattern is heated for curing at temperature which does not cause swelling of it, and subsequently the resist pattern is heated at temperature sufficient for allowing it to swell.

19. The method according to Claim 15, wherein heating sufficient for allowing the resist pattern to swell is conducted at temperature from 140 - 180°C.
